# EUROPÄISCHE PATENTSCHRIFT

(11) **EP 0 696 722 B1**
(45) Veröffentlichungstag und Bekanntmachung des Hinweises auf die Patenterteilung: **03.09.1997**
(21) Anmeldenummer: 95109700.5
(22) Anmeldetag: 22.06.1995
(51) Int. Cl.: G01D 5/249, H03M 1/24, G01D 5/34

(54) **Positionsmesseinrichtung**
Position-measuring device
Dispositif de mesure de positions

(30) Priorität: 12.08.1994 DE 4428590
(43) Veröffentlichungstag der Anmeldung: 14.02.1996
(73) Patentinhaber: Dr. Johannes Heidenhain GmbH, D-83292 Traunreut (DE)
(72) Erfinder: Affa, Alfred, D-83371 Stein/Traun (DE)

(56) Entgegenhaltungen:
- DE-A- 2 416 212
- DE-A- 3 914 739
- DE-A- 4 037 545
- DE-A- 4 244 178

## Beschreibung

Die Erfindung betrifft eine Positionsmeßeinrichtung gemäß dem Oberbegriff des Anspruches 1.

Derartige Meßeinrichtungen werden insbesondere bei Bearbeitungsmaschinen zur Messung der Relativlage eines Werkzeuges sowie bei Koordinatenmeßmaschinen zur Ermittlung von Lage und Abmessung von Prüfobjekten eingesetzt.

Die an den Referenzmarken erzeugten elektrischen Impulse können zum Reproduzieren von Referenzpositionen im Zähler, zum Anfahren einer bestimmten Position zu Beginn oder nach Unterbrechungen einer Messung, zur Kontrolle und Korrektur des Zählerstandes sowie zur Beaufschlagung einer nachgeschalteten Steuereinrichtung dienen.

Um bei inkrementalen Meßeinrichtungen die Referenzpositionen zu ermitteln, sind zwei Grundprinzipien bekannt:

Bei dem einen Prinzip ist parallel zur Inkrementalteilung eine Reihe von identischen Referenzmarken in festgelegten Abständen angebracht. Jeder Referenzmarke, die beim Meßvorgang zur Wirkung gelangen soll, ist ein Schaltmittel zugeordnet. Die elektrischen Ausgänge des Schaltmittels und des Abtastelementes der Referenzmarken sind an eine Auswerteeinheit angeschlossen, die nur dann einen Steuerimpuls an den Zähler abgibt, wenn gleichzeitig am Abtastelement der Referenzmarke und am Schaltmittel ein elektrisches Signal anliegt. Der Steuerimpuls bewirkt, daß im Zähler ein vorbestimmter Zählerwert gesetzt wird. Eine derartige Meßeinrichtung ist beispielsweise aus der DE 25 40 412 C3 bekannt.

Bei dem weiteren Prinzip ist ebenfalls parallel zur Inkrementalteilung zumindest eine Referenzmarkenspur mit gleichen Referenzmarken angeordnet. Jede Referenzmarke hat von einer anderen Referenzmarke einen besonderen, die Referenzmarke kennzeichnenden Abstand. Diese unterschiedlichen Abstände zwischen Referenzmarken werden durch die Abtastung der inkrementalen Teilung durch Zählen der Meßschritte (Inkremente) bestimmt. Eine derartige Meßeinrichtung ist beispielsweise aus der DE 24 16 212 C bekannt. Bei der EP 0 246 404 werden zur Bestimmung des Absolutwertes einer Referenzmarke zwei aufeinanderfolgende Abstände zwischen Referenzmarken herangezogen.

In der DE 42 43 778 A1 ist ebenfalls eine Positionsmeßeinrichtung beschrieben, bei der eine Inkrementalteilung zur Bildung von Zählsignalen und eine weitere Spur zur Bestimmung der Absolutposition vorgesehen ist. Diese weitere Spur besteht bei einem Ausführungsbeispiel aus einer Folge von gleichen Referenzmarken in unterschiedlichen Abständen, so daß die einzelnen Referenzmarkenpositionen durch den charakteristischen Abstand zweier aufeinanderfolgender Referenzmarken unterscheidbar sind. Bei einem weiteren Ausführungsbeispiel besteht die weitere Spur aus Markierungen, die einen sequentiellen Code zur Erzeugung von positionsbestimmenden Codewörtern bilden.

Es wurde bereits versucht Meßeinrichtungen zu schaffen, bei denen beide Prinzipien in einer Positionsmeßeinrichtung vereinigt sind. Eine dieser Meßeinrichtungen ist in der DE 39 14 739 C2 beschrieben. Parallel zur Inkrementalspur ist eine Referenzmarkenspur angeordnet, in der nur identische Referenzmarken in aufeinanderfolgend unterschiedlichen Abständen angeordnet sind. Durch Auszählen der Inkremente von einer Referenzmarke zur nächsten, wird deren absolute Position bestimmt. Eine weitere Spur weist eine Reihe von Markierungen auf, die in gleichen Abständen angeordnet sind. Zur Auswahl von Referenzmarken sind diese Markierungen bestimmten Referenzmarken zugeordnet. Aus diesen Markierungen kann wiederum eine ausgewählt werden, wodurch nur die ihr zugeordnete Referenzmarke zur Wirkung gebracht wird. Weiterhin ist ein Betriebsarten-Umschalter vorgesehen, mit dem die Auswertung aller Referenzmarken nach dem Prinzip der Abstandscodierung oder die Auswertung nur der markierten Referenzmarken ermöglicht wird.

Diese Positionsmeßeinrichtung hat den Nachteil, daß zur Auswahl von gleichbeabstandeten Referenzmarken eine zusätzliche Spur erforderlich sowie zur weiteren Auswahl einer der Markierungen eine dritte Spur erforderlich wird. Darüberhinaus müssen die Markierungen den Referenzmarken exakt zugeordnet werden, was aufwendige Justierarbeiten erforderlich macht. Ein weiterer Nachteil besteht darin, daß bei großen Meßlängen aufeinanderfolgende Referenzmarken einen großen Abstand zueinander aufweisen müssen, um über die gesamte Meßlänge unterschiedliche Abstände zu erreichen. Der kürzest mögliche Abstand der Markierungen der zweiten Spur entspricht aber dem größten Abstand der Referenzmarken, so daß die mittels der Markierungen ausgewählten Referenzmarken für das zweite Meßprinzip einen für die Praxis zu großen Abstand aufweisen.

Um diesen zuletzt genannten Nachteil zu beheben, sind gemäß der DE 42 44 178 A1 - von der diese Erfindung ausgeht - zumindest zwei Spuren mit Referenzmarken vorgesehen. Dies hat den Nachteil, daß neben der Inkrementalteilung relativ viel Platz zur Verfügung stehen muß, und daß die Abtasteinheit eine große Breite aufweist.

Der Erfindung liegt die Aufgabe zugrunde, durch Vereinheitlichung der Positionsmeßeinrichtung die Herstellungs- und Lagerkosten zu reduzieren und eine breite Einsatzmöglichkeit zu gewährleisten, wobei gleichzeitig eine geringe Baugröße der Positionsmeßeinrichtung erreicht werden soll.

Diese Aufgabe wird durch die Positionsmeßeinrichtung mit den Merkmalen des Anspruches 1 gelöst.

Vorteilhafte Ausgestaltungen der Erfindung sind in den abhängigen Ansprüche angegeben.

Die Vorteile der Erfindung liegen darin, daß die Positionsmeßeinrichtung den Bedürfnissen des Anwenders leicht angepaßt werden kann, und trotzdem eine geringe Baugröße aufweist.

Mit Hilfe eines Ausführungsbeispieles wird die Erfindung nachstehend anhand der Zeichnungen näher erläutert.

Es zeigt
- Figur 1: eine lichtelektrische inkrementale Längenmeßeinrichtung;
- Figur 2: den Maßstab der Längenmeßeinrichtung;
- Figur 3: einen Ausschnitt des Maßstabes gemäß Figur 2;
- Figur 4: einen weiteren Ausschnitt des Maßstabes gemäß Figur 2;
- Figur 5: ein Signaldiagramm;
- Figur 6: ein zweites Signaldiagramm;
- Figur 7: ein drittes Signaldiagramm und
- Figur 8: ein Prinzip zur Ermittlung der Absolutposition.

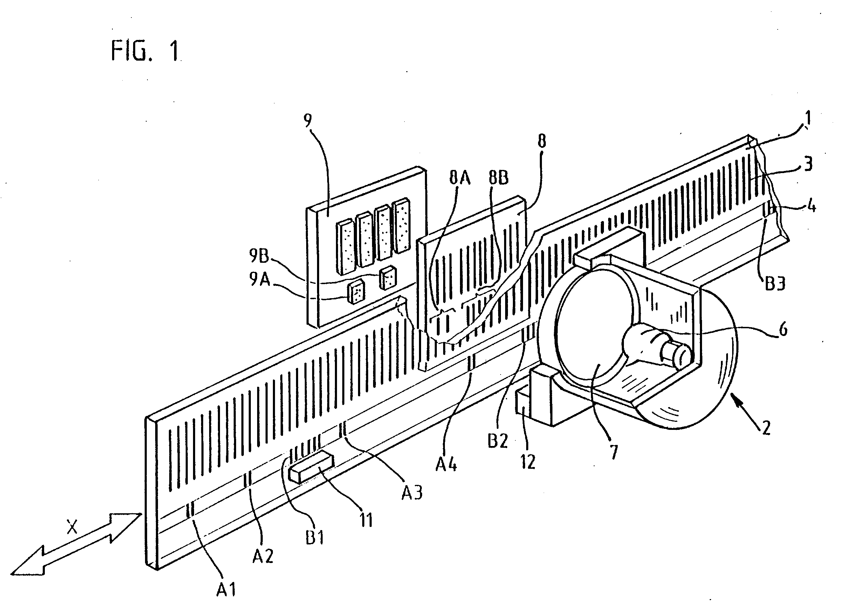

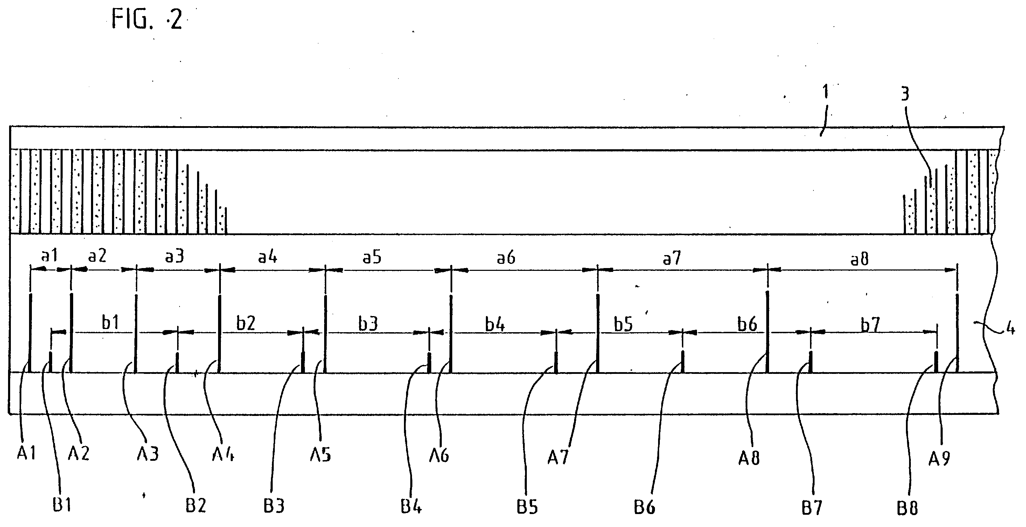

Die Figur 1 zeigt eine lichtelektrische inkrementale Längenmeßeinrichtung mit einem Maßstab 1, der relativ zu einer Abtasteinheit 2 in Meßrichtung X verschiebbar ist. Auf dem Maßstab 1, der in Figur 2 im Detail dargestellt ist, ist in einer Spur eine Inkrementalteilung 3 sowie in einer weiteren Spur 4 eine Vielzahl von Referenzmarken A1 bis A9 und B1 bis B8 aufgebracht. Zur lichtelektrischen Abtastung der Inkrementalteilung 3 und der Spur 4 ist die Abtasteinheit 2 vorgesehen. Diese umfaßt eine Lichtquelle 6, deren Licht von einem Kollimator 7 gebündelt und auf den Maßstab 1 gerichtet wird. Das Licht fällt durch die transparenten Bereiche der Inkrementalteilung 3 sowie der Referenzmarken A1 bis A9, B1 bis B8 sowie durch die Abtastplatte 8 auf eine photoelektrische Empfängeranordnung 9.

Wie in Figur 2 im Detail dargestellt ist, weist die Inkrementalteilung 3 gleichbreite Striche und Lücken auf. Bei der lichtelektrischen Abtastung werden periodische analoge elektrische Signale erzeugt, aus denen in bekannter Weise durch Triggerung zählbare Rechtecksignale gebildet werden, die nachfolgend als Zählsignale bezeichnet werden.

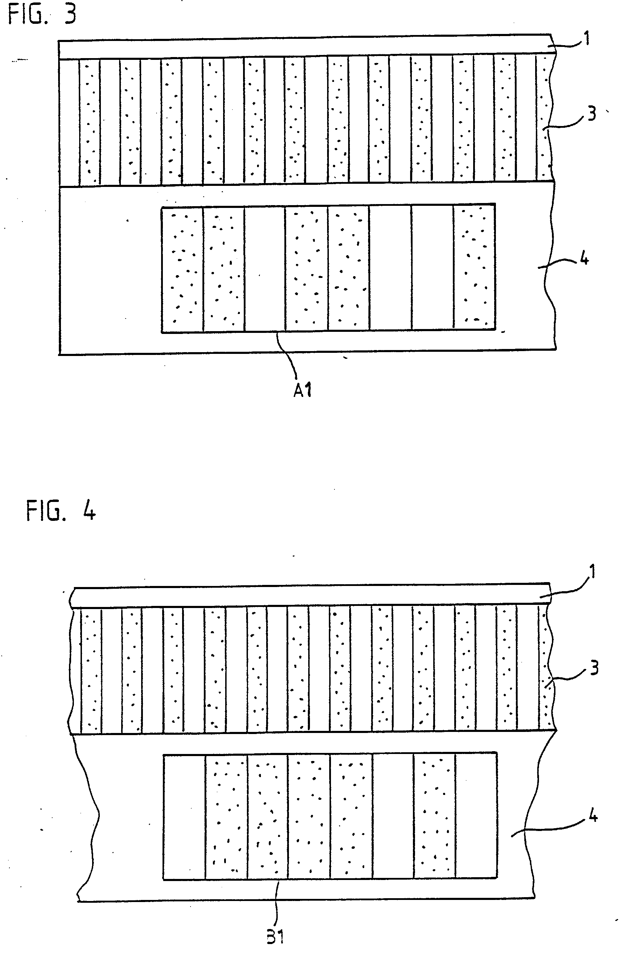

Parallel zur Inkrementalteilung 3 sind in der Spur 4 zwei Folgen unterschiedlich ausgebildeter Referenzmarken A1 bis A9 sowie B1 bis B8 aufgebracht. Die erste Folge gleicher Referenzmarken A1 bis A9 ist in aufeinanderfolgend unterschiedlichen Abständen a1 bis a8 vorgesehen. Die zweite Folge gleicher Referenzmarken B1 bis B8 ist in aufeinanderfolgend gleichen Abständen b1 bis b7 = 50mm aufgebracht. Zur Unterscheidung der zwei Folgen von Referenzmarken A1 bis A9 sowie B1 bis B8 sind sie in Figur 2 durch unterschiedlich hohe Striche dargestellt. Tatsächlich besteht jede einzelne Referenzmarke A1 bis A9 und B1 bis B8 aus einer Kombination von opaken Strichen und transparenten Lücken, die sich über mehrere Inkremente der Inkrementalteilung 3 erstreckt. In Figur 3 ist eine einfach ausgebildete Referenzmarke A1 und in Figur 4 eine Referenzmarke B1 dargestellt. In der Praxis reichen diese Referenzmarken A1, B1 nicht nur über 8 Inkremente der Inkrementalteilung 3, sondern über eine Vielzahl, beispielsweise etwa 70. Durch geschickte Kombinationen der opaken Striche und transparenten Lücken einer Referenzmarke A1, B1 erreicht man, daß bei der Abtastung ein schmaler, auf einen inkrementellen Zählimpuls zentrierter Referenzmarkenimpuls RA, RB entsteht.

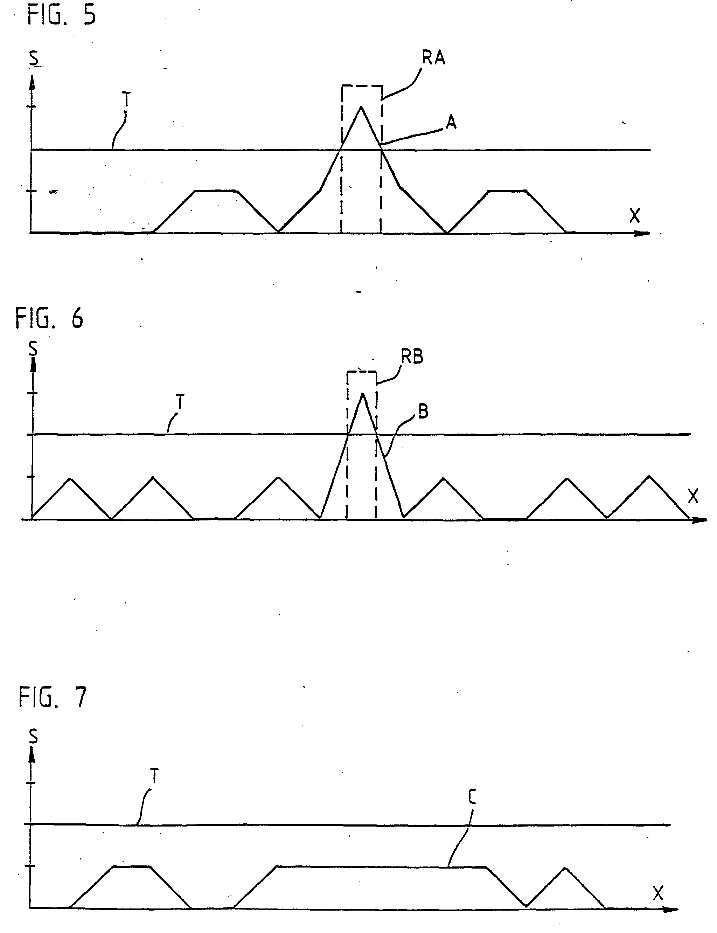

Zur Abtastung der Referenzmarken A1 bis A9 und B1 bis B8 sind in der Abtasteinheit 2 zwei Abtastfelder 8A, 8B vorgesehen. Das Abtastfeld 8A hat eine Strich-Lücken-Verteilung wie die Referenzmarken A1 bis A9. Die Strich-Lücken-Verteilung des Abtastfeldes 8B entspricht der Strich-Lücken-Verteilung der Referenzmarken B1 bis B8. Bei der Abtastung jeder Referenzmarke A1 bis A9 mit dem Abtastfeld 8A wird im zugeordneten Empfangsfeld 9A ein Signal A mit der Amplitude S erzeugt, das in Figur 5 dargestellt ist. Bei der Abtastung jeder Referenzmarke B1 bis B8 mit dem Abtastfeld 8B wird im zugeordneten Empfangsfeld 9B ein Signal B erzeugt, das in Figur 6 dargestellt ist. Durch Triggerung der Signale A, B wird jeweils ein Referenzmarkenimpuls RA, RB mit der Breite entsprechend etwa einem Inkrement der Inkrementalteilung 3 erzeugt. Da die zwei Folgen von Referenzmarken A1 bis A9 sowie B1 bis B8 in einer einzigen Spur 4 ineinander verschachtelt angeordnet sind, ist es wesentlich, daß die Referenzmarken A1 bis A9 sowie B1 bis B8 derart ausgebildet sind, daß bei der Abtastung der Referenzmarken A1 bis A9 mittels des Abtastfeldes 8B sowie bei der Abtastung der Referenzmarken B1 bis B8 mittels des Abtastfeldes 8A kein Referenzimpuls RB oder RA erzeugt wird. Wie in Figur 7 dargestellt ist, liegt in beiden Fällen der von den entsprechenden Empfangsfeldern 9B, 9A erzeugte Pegel S des Signales C unterhalb des zur Bildung eines Referenzimpulses RB oder RA erforderlichen Signalpegels T.

Durch diese vorteilhafte Ausgestaltung eines Maßstabes 1 ist es möglich, daß der Anwender selbst zwischen zwei Betriebsarten auswählen kann. Bei der ersten Betriebsart wird nur die erste Folge von Referenzmarken A1 bis A9 ausgewertet, indem ausschließlich die Referenzmarkenimpulse RA einer Auswerteeinheit 13 zugeführt werden. In bekannter Weise wird durch Zählung der Inkremente zwischen zwei aufeinanderfolgenden Referenzmarken A1 bis A9 jeder Referenzmarke A1 bis A9 eine Absolutposition eindeutig zugeordnet. Hierzu ist in einem Speicherbereich der Auswerteeinheit 13 für jeden Abstand a1 bis a8 eine Absolutposition abgespeichert. Die Zuordnung einer Absolutposition kann auch durch mehrere Abstände a1 bis a8 erfolgen, wie in der EP 0 246 404 A2 beschrieben ist.

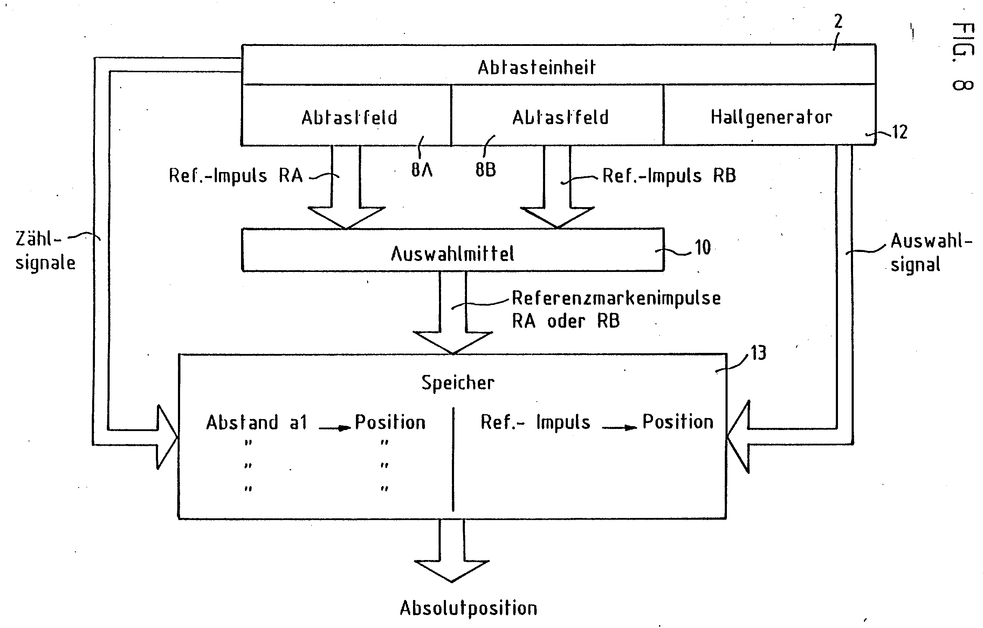

Bei der zweiten Betriebsart wird nur die zweite Folge von gleichbeabstandeten Referenzmarken B1 bis B8 in an sich bekannter Weise (DE 25 40 412 C3) ausgewertet. Hierbei wird ebenfalls die Inkrementalteilung 3 zur Erzeugung von Zählsignalen abgetastet. Einer der Referenzmarken B1 bis B8 ist ein Auswahlmittel 11 zugeordnet, wodurch diese Referenzmarke B1 beim Überfahren mit der Abtasteinheit 2 aus der Reihe von Referenzmarken B1 bis B8 auswählbar ist und somit nur diese zur Wirkung gebracht wird. Beim Erkennen dieser ausgewählten Referenzmarke B1 wird der Zählerstand des Positionsanzeigegerätes auf einen vorbestimmten Wert gesetzt. Wie in Figur 8 schematisch dargestellt, ist hierzu in der Auswerteeinheit 13 ein Speicherbereich vorgesehen, in dem diese, der Referenzmarke B1 zugeordnete Absolutposition abgespeichert ist.

Als Auswahlmittel ist in Figur 1 ein Magnet 11 dargestellt, der beim Vorbeibewegen der Abtasteinheit 2 einen darauf angebrachten Hallgenerator 12 ansteuert. Der Hallgenerator 12 erzeugt ein Auswahlsignal, das der Auswerteeinheit 13 zugeführt wird, so daß nur beim gleichzeitigen Auftreten des Auswahlsignales sowie des Referenzmarkenimpulses RB eine Absolutposition ausgegeben wird. Anstelle der Absolutposition kann auch nur ein Steuersignal an ein Positionsanzeigegerät oder eine numerische Steuerung gegeben werden.

Zur Umschaltung zwischen den zwei beschriebenen Betriebsarten ist ein Auswahlmittel 10 vorgesehen. Dieses Auswahlmittel 10 ist vorzugsweise als Umschalter an der Abtasteinheit 2 oder dem Positionsanzeigegerät ausgebildet, so daß entweder die Referenzmarkenimpulse RA oder RB der Auswerteeinheit 13 zugeführt werden.

Es liegt aber auch im Rahmen der Erfindung, wenn die Betriebsart bereits beim Hersteller, z.B. durch Verlöten einer bestimmten Verbindung in der Abtasteinheit 2 ausgewählt wird.

Ebenso kann die Auswahl durch Abdecken des nicht verwendeten Empfangsfeldes 9A oder 9B bzw. des nicht verwendeten Abtastfeldes 8A oder 8B erfolgen. Hierzu können auch von außen betätigbare Blenden eingesetzt werden.

Eine weitere Möglichkeit der Betriebsartenauswahl besteht darin, daß eine Abtastplatte 8 mit nur einem Abtastfeld 8A oder 8B und/oder ein Empfänger 9 mit nur einem Empfangsfeld 9A oder 9B eingesetzt wird.

Die Erfindung kann auch bei Winkelmeßeinrichtungen erfolgreich eingesetzt werden. Sie ist darüberhinaus nicht auf das lichtelektrische Abtastprinzip beschränkt, sondern beispielsweise auch bei magnetischen Meßeinrichtungen einsetzbar.

## Patentansprüche

1. Positionsmeßeinrichtung mit wenigstens einer Inkrementalteilung (3), die von einer Abtasteinheit (2) zur Bildung von Zählsignalen abgetastet wird, und mit einer ersten Folge von gleichen Referenzmarken (A1 bis A9), die in unterschiedlichen Abständen (a1 bis a8) angeordnet sind, so daß diese Referenzmarken (A1 bis A9) durch charakteristische Abstände (a1 bis a8) zwischen mehreren Referenzmarken (A1 bis A8) dieser Folge unterscheidbar sind, sowie mit zumindest einer weiteren Referenzmarke (B1 bis B8), dadurch gekennzeichnet, daß die erste Folge von Referenzmarken (A1 bis A9) und die zumindest weitere Referenzmarke (B1 bis B8) in einer einzigen Spur (4) vorgesehen sind, wobei sich die Referenzmarken (A1 bis A9) der einen Folge von der zumindest einen weiteren Referenzmarke (B1 bis B8) dieser Spur (4) unterscheiden.

2. Positionsmeßeinrichtung nach Anspruch 1, dadurch gekennzeichnet, daß in der Spur (4) eine erste Folge von gleichen Referenzmarken (A1 bis A9) in unterschiedlichen Abständen (a1 bis a8) sowie eine zweite Folge von gleichen Referenzmarken (B1 bis B8) in aufeinanderfolgend gleichen Abständen (b1 bis b7) angeordnet sind, wobei sich die Referenzmarken (A1 bis A9) der einen Folge von den Referenzmarken (B1 bis B8) der zweiten Folge unterscheiden.

3. Positionsmeßeinrichtung nach Anspruch 2, dadurch gekennzeichnet, daß in dieser Spur (4) eine zweite Folge von gleichen Referenzmarken (B1 bis B8) in aufeinanderfolgend gleichen Abständen (b1 bis b7) angeordnet ist, wobei sich die Referenzmarken (B1 bis B8) der ersten Folge von den Referenzmarken (B1 bis B8) der zweiten Folge unterscheiden,
daß weiterhin entweder die erste Folge von Referenzmarken (A1 bis A9) zur Erzeugung eines Referenzmarkenimpulses (RA) an jeder dieser Referenzmarken (A1 bis A9) wirksam ist, wobei die Referenzmarkenimpulse (RA) einer Auswerteeinheit (13) zugeführt werden, welche die Absolutposition einer Referenzmarke (A1 bis A9) aus den durch Zählsignale gewonnenen charakteristischen Abständen (a1 bis a8) zwischen Referenzmarken (A1 bis A9) ermittelt, oder
die zweite Folge von Referenzmarken (B1 bis B8) wirksam ist, und zumindest einer dieser Referenzmarken (B1 bis B8) ein Auswahlmittel (11) zugeordnet ist, auf dessen Veranlassung wenigstens diese Referenzmarke (B1) ausgewählt und ein Referenzmarkenimpuls (RB) der Auswerteeinheit (13) zugeführt wird.

4. Positionsmeßeinrichtung nach Anspruch 1, 2 oder 3, dadurch gekennzeichnet, daß jede der Referenzmarken (A1 bis A9, B1 bis B8) aus einer Reihe von aufeinanderfolgenden opaken oder nicht reflektierenden Strichen sowie transparenten oder reflektierenden Lücken besteht, die von der Abtasteinheit (2) lichtelektrisch abgetastet werden, wobei in der Abtasteinheit (2) ein erstes tastfeld (8B) mit identischer Strich-Lücken-Verteilung wie die Referenzmarken (A1 bis A9) der ersten Folge und/oder ein zweites Abtastfeld(8B) mit identischer Strich-Lücken-Verteilung wie die zumindest eine weitere Referenzmarke (B1 bis B8) enthalten ist, und daß sich das Strich-Lücken-Verhältnis der Referenzmarken (A1 bis A9) der ersten Folge von dem Strich-Lücken-Verhältnis der zumindest einen weiteren Referenzmarke (B1 bis B8) derart unterscheidet, daß bei der Abtastung einer Referenzmarke (A1 bis A9) der ersten Folge mit dem zweiten Abtastfeld (8B) sowie bei der Abtastung der zumindest einen weiteren Referenzmarke (B1 bis B8) mit dem ersten Abtastfeld (8A) kein Referenzimpuls (RA, RB) erzeugt wird.

5. Positionsmeßeinrichtung nach einem der Ansprüche 2, 3 oder 4, dadurch gekennzeichnet, daß ein Auswahlmittel (10) vorgesehen ist, mit dem wahlweise folgende Betriebsarten auswählbar sind:
a) Abtasten der Inkrementalteilung (3) und gleichzeitig die erste Folge von Referenzmarken (A1 bis A9) zur Erzeugung eines Referenzmarkenimpulses (RA) an jeder dieser Referenzmarken (A1 bis A9), wobei die Referenzmarkenimpulse (RA) einer Auswerteeinheit (13) zugeführt werden, welche die Absolutposition einer Referenzmarke (A1 bis A9) aus den durch Zählsignale gewonnenen charakteristischen Abständen (a1 bis a8) zwischen Referenzmarken (A1 bis A9) ermittelt oder
b) Abtasten der Inkrementalteilung (3) und gleichzeitig der zweiten Folge von Referenzmarken (B1 bis B8), wobei zumindest einer dieser Referenzmarken (B1 bis B8) ein Auswahlmittel (11) zugeordnet ist, auf dessen Veranlassung wenigstens diese Referenzmarke (B1) ausgewählt und ein Referenzmarkenimpuls (RB) der Auswerteeinheit (13) zugeführt wird.

6. Positionsmeßeinrichtung nach Anspruch 5, dadurch gekennzeichnet, daß das Auswahlmittel (10) zur Betriebsartenauswahl a) oder b) ein an der Positionsmeßeinrichtung angebrachter elektrischer Umschalter ist.

7. Positionsmeßeinrichtung nach Anspruch 5, dadurch gekennzeichnet, daß das Auswahlmittel (10) zur Betriebsartenwahl a) oder b) eine Abdeckung ist, die in dem Strahlengang zwischen Lichtquelle (6) und einem dem ersten Abtastfeld (8A) zugeordneten ersten Empfangsfeld (9A) oder in dem Strahlengang zwischen Lichtquelle (6) und einem dem zweiten Abtastfeld (8B) zugeordneten zweiten Empfangsfeld (9B) vorgesehen ist.

8. Positionsmeßeinrichtung nach einem der Ansprüche 3 bis 5, dadurch gekennzeichnet, daß das einer Referenzmarke (B1) zugeordnete Auswahlmittel ein Magnet (11) ist, der von einem Hallgenerator (12) der Abtasteinheit (2) abgetastet wird.

## Claims

1. Position-measuring device with at least one incremental division (3) which is scanned by a scanner unit (2) in order to form counter signals, and with a first sequence of identical reference markings (A1 to A9) disposed at different intervals (a1 to a8), so that said reference markings (A1 to A9) may be differentiated by characteristic intervals (a1 to a8) between a plurality of reference markings (A1 to A8) of this sequence, and with at least one further reference marking (B1 to B8), **characterised in that** the first sequence of reference markings (A1 to A9) and the at least further reference marking (B1 to B8) are provided in one single track (4), the reference markings (A1 to A9) of one sequence differing from the at least one further reference marking (B1 to B8) of this track (4).

2. Position-measuring device according to claim 1, characterised in that there are disposed in the track (4) a first sequence of identical reference markings (A1 to A9) at different intervals (a1 to a8), and a second sequence of identical reference markings (B1 to B8) at successive different intervals (b1 to b7), the reference markings (A1 to A9) of one sequence differing from the reference markings (B1 to B8) of the second sequence.

3. Position-measuring device according to claim 2, characterised in that in this track (4) there is disposed a second sequence of identical reference markings (B1 to B8) at successive identical intervals (b1 to b7), the reference markings (B1 to B8) of the first sequence differing from the reference markings (B1 to B8) of the second sequence,
in that, further, either the first sequence of reference markings (A1 to A9) is active in generating a reference marking pulse (RA) at each of these reference markings (A1 to A9), the reference marking pulses (RA) being passed to an evaluation unit (13), which determines the absolute position of a reference marking (A1 to A9), obtained by counter signals, from the characteristic intervals (a1 to a8) between reference markings (A1 to A9), or
the second sequence of reference markings (B1 to B8) is active, and there is associated with at least one of these reference markings (B1 to B8) a selector means (11), upon whose instigation at least this reference marking (B1) is selected, and a reference marking pulse (RB) is passed to the evaluation unit (13).

4. Position-measuring device according to claim 1, 2 or 3, characterised in that each of the reference markings (A1 to A9, B1 to B8) comprises a series of successive opaque or non-reflective stripes and transparent or reflective gaps, which are photoelectrically scanned by the scanner unit (2), there being contained in the scanner unit (2) a first scanner field (8A) with a strip/gap distribution identical with the reference markings (A1 to A9) of the first sequence, and/or a second scanner field (8B) with a strip/gap distribution identical with the at least one further reference marking (B1 to B8), and in that the strip/gap ratio of the reference markings A1 to A9) of the first sequence differs from the strip/gap ratio of the at least one further reference marking (B1 to B8) in such a way that, when a reference marking (A1 to A9) of the first sequence is scanned by the second scanner field (8B), and when the at least one further reference marking (B1 to B8) is scanned by the first scanner field (8A), no reference pulse (RA, RB) is generated.

5. Position-measuring device according to one of claims 2, 3 or 4, characterised in that a selector means (10) is provided, by means of which the following operational modes may be selected at will:
a) Scanning of the incremental division (3) and simultaneously of the first sequence of reference markings (A1 to A9) in order to generate a reference marking pulse (RA) at each of these reference markings (A1 to A9), the reference marking pulses (RA) being passed to an evaluation unit (13) which determines the absolute position of a reference marking (A1 to A9) from the characteristic intervals (al to a8), obtained by counter signals, between reference markings (A1 to A9), or
b) Scanning of the incremental division (3) and simultaneously of the second sequence of reference markings (B1 to B8), there being associated with at least one of these reference markings (B1 to B8) a selector means (11), upon whose instigation at least this reference marking (B1) is selected, and a reference marking pulse (RB) is passed to the evaluation unit (13).

6. Position-measuring device according to claim 5, characterised in that the selector means (10) for selecting the operational mode a) or b) is an electrical change-over switch mounted on the position-measuring device.

7. Position-measuring device according to claim 5, characterised in that the selector means (10) for selecting the operational mode a) or b) is a covering provided in the beam path between light source (6) and a first receiver field (9A) associated with the first scanner field (8A), or in the beam path between light source (6) and a second receiver field (9B) associated with the second scanner field (8B).

8. Position-measuring device according to one of claims 3 to 5, characterised in that the selector means associated with a reference marking (B1) is a magnet (11), which is scanned by a Hall generator (12) of the scanner unit (2).

## Revendications

1. Dispositif de mesure de position avec au moins une graduation incrémentale (3) qui est palpée par une unité de lecture (2) aux fins de former des signaux de comptage et avec une première série de repères de référence (A1 à A9) identiques qui sont disposés à des distances (a1 à a8) différentes, de manière telle que lesdits repères de référence (A1 à A9) puissent être différenciés par des distances (a1 à a8) caractéristiques entre plusieurs repères de référence (A1 à A8) de la série et avec au moins un repère de référence (B1 à B8) supplémentaire, caractérisé par le fait que la première série de repères de référence (A1 à A9) et le repère de référence (B1 à B8) supplémentaire, au nombre d'au moins un, sont prévus sur une piste (4) unique, les repères de référence (A1 à A9) d'une série étant différents du repère de référence (B1 à B8) supplémentaire, au nombre d'au moins un, de cette piste (4).

2. Dispositif de mesure de position selon la revendication 1, caractérisé par le fait qu'une première série de repères de référence (A1 à A9) identiques, avec des distances (a1 à a8) différentes, et une deuxième série de repères de référence (B1 à B8) identiques, avec des distances (b1 à b7) successives constantes, sont disposées sur la piste (4), les repères de référence (A1 à A9) d'une série étant différents des repères de référence (B1 à B8) de la deuxième série.

3. Dispositif de mesure de position selon la revendication 2, caractérisé par le fait qu'une deuxième série de repères de référence (B1 à B8) identiques, avec des distances (b1 à b7) successives constantes, est disposée sur cette piste (4), les repères de référence (B1 à B8) de la première série étant différents des repères de référence (B1 à B8) de la deuxième série, caractérisé par le fait que soit la première série de repères de référence (A1 à A9) est active pour produire une impulsion de repère de référence (RA) au niveau de chacun des repères de référence (A1 à A9), les impulsions de repère de référence (RA) étant transmises à une unité de traitement (13) qui détermine la position absolue d'un repère de référence (A1 à A9) à partir des distances (a1 à a8) caractéristiques entre les repères de référence (A1 à A9) obtenues par des signaux de comptage, soit la deuxième série de repères de référence (B1 à B8) est active et au moins un moyen de sélection (11) est associé à au moins un des repères de référence (B1 à B8), moyen grâce auquel au moins ledit repère de référence (B1) est sélectionné et une impulsion de repère de référence (RB) est envoyée à l'unité de traitement (13).

4. Dispositif de mesure de position selon la revendication 1, 2 ou 3, caractérisé par le fait que chaque repère de référence (A1 à A9, B1 à B8) se compose d'une série de traits consécutifs opaques ou non réfléchissants et de d'espaces transparents ou réfléchissants qui sont palpés par voie opto-électronique par une unité de palpage (2), l'unité de palpage comportant une première zone de palpage (8A), avec une distribution de traits et d'espaces identique à celle des repères de référence (A1 à A9) de la première série, et/ou une deuxième zone de palpage (8B), avec une distribution de traits et d'espaces identique à celle du repère de référence (B1 à B8) supplémentaire, au nombre d'au moins un, et par le fait que le rapport trait-espace des repères de référence (A1 à A9) de la première série diffère du rapport trait-espace du repère de référence (B1 à B8) supplémentaire au nombre d'au moins un de manière telle que lors du palpage d'un repère de référence (A1 à A9) de la première série à l'aide de la deuxième zone de palpage (8B) et lors du palpage du repère de référence (B1 à B8) supplémentaire au nombre d'au moins un à l'aide de la première zone de palpage (8A) aucune impulsion de référence (RA, RB) ne soit produite.

5. Dispositif de mesure de position selon une des revendications 2, 3 ou 4, caractérisé par le fait qu'un moyen de sélection (10) est prévu à l'aide duquel les modes de fonctionnement suivants peuvent être sélectionnés:
a) palpage de la graduation incrémentale (3) et simultanément de la première série de repères de référence (A1 à A9) aux fins de produire une impulsion de repère de référence (RA) au niveau de chacun desdits repères de référence (A1 à A9), les impulsions de repère de référence (RA) étant envoyées à une unité de traitement (13) qui calcule la position absolue d'un repère de référence (A1 à A9) à partir des distances caractéristiques (a1 à a8) entres repères de référence (A1 à A9) obtenues avec les signaux de comptage,
b) palpage de la graduation incrémentale (3) et simultanément de la deuxième série de repères de référence (B1 à B8), un moyen de sélection (11) étant associé à au moins un desdits repères de référence (B1 à B8), moyen qui déclenche la sélection d'au moins ce repère de référence (B1) et l'envoi à l'unité de traitement (13) d'une impulsion (RB) de repère de référence.

6. Dispositif de mesure de position selon la revendication 5, caractérisé par le fait que le moyen de sélection (10) pour la sélection du mode de fonctionnement a) ou b) est un commutateur électrique monté sur le dispositif de mesure de position.

7. Dispositif de mesure de position selon la revendication 5, caractérisé par le fait que le moyen de sélection (10) pour la sélection du mode de fonctionnement a) ou b) est un masque qui est prévu sur le trajet des rayons entre la source lumineuse (6) et une première zone de réception (9A) associée à la première zone de palpage (8A) ou sur le trajet des rayons entre la source lumineuse (6) et une deuxième zone de réception (9B) associée à la deuxième zone de palpage (8B).

8. Dispositif de mesure de position selon l'une des revendications 3 à 5, caractérisé par le fait que le moyen de sélection associé à un repère de référence (B1) est un aimant (11) qui est palpé par un générateur à effet Hall (12) de l'unité de palpage (2).
